# EUROPÄISCHE PATENTSCHRIFT

(11) **EP 1 113 908 B1**
(45) Veröffentlichungstag und Bekanntmachung des Hinweises auf die Patenterteilung: **17.07.2002**
(21) Anmeldenummer: 99944518.2
(22) Anmeldetag: 26.08.1999
(51) Int. Cl.: B26D 1/00, C23C 14/48

(54) **MESSER ZUM SCHNEIDEN LAUFENDER MATERIALBAHNEN**
BLADES FOR CUTTING MOVING LINES OF MATERIAL
LAMES PERMETTANT DE COUPER DES BANDES DE MATERIAU QUI DEFILENT

(30) Priorität: 08.09.1998 DE 19840950
(43) Veröffentlichungstag der Anmeldung: 11.07.2001
(73) Patentinhaber: Voith Paper Patent GmbH, 89522 Heidenheim (DE)
(72) Erfinder: RÜCKERT, Hans, D-40882 Ratingen (DE); SCHOOF, Ulrich, D-40591 Düsseldorf (DE)
(74) Vertreter: Knoblauch, Andreas, Dr.-Ing.
(86) Internationale Anmeldenummer: EP9906257
(87) Internationale Veröffentlichungsnummer: WO0013860

(56) Entgegenhaltungen:
- WO-A-95/29274
- WO-A-97/39862
- DE-A- 2 504 817
- DE-C- 3 607 907
- US-A- 5 753 076

## Beschreibung

### Technisches Gebiet

Die Erfindung betrifft ein Messer, insbesondere zum Schneiden laufender Materialbahnen, wie Papier- oder Kartonbahnen, Kunststoff- oder Metallfolien.

### Stand der Technik

In Verarbeitungsmaschinen für Papier- oder Kartonbahnen, Kunststoff- oder Metallfolien werden verschiedene Messertypen eingesetzt, um die durchlaufenden Bahnen längs oder quer zu schneiden. So enthalten Rollenschneidmaschinen für Papier- oder Kartonbahnen oder Kunststoffolien üblicherweise eine Längsschneidevorrichtung mit mehreren paarweise angeordneten Kreismessem, wobei jeweils ein Kreismesserpaar die Bahn in Längsrichtung durchtrennt. So werden aus einer breiten Materialbahn einzelne schmalere Bahnen hergestellt, die anschließend zu Wickelrollen aufgewickelt werden. Querschneidemaschinen zur Herstellung von einzelnen Bögen aus einer Materialbahn enthalten neben einer Längsschneidevorrichtung eine Querschneidevorrichtung, die bekannter Weise aus zwei Messertrommeln besteht, die auf ihrer Mantelfläche jeweils mit einem oder mehreren sich über die Trommellänge erstreckenden Quermesser bestückt sind.

Bekannterweise bestehen die Kreismesserpaare von Längsschneidevorrichtungen jeweils aus einem die Bahn beim Schneiden abstützenden Topfmesser und einem in die Bahn eintauchenden Spitzmesser, deren Schneidkanten exakt zueinander in der gewünschten Schnittposition positioniert werden. Üblicherweise ist das als Untermesser eingesetzte Topfmesser angetrieben, während das scheibenförmige Spitzmesser als Obermesser frei drehbar gelagert ist (DE 34 19 843-C2).

Üblicherweise sind die Kreismesser in Längsschneidevorrichtungen und die Quermesser in Querschneidevorrichtungen aus Stahl gefertigt. Sie unterliegen beim Schneiden einem hohen Verschleiß und müssen daher in regelmäßigen Abständen nachgeschliffen und/oder ausgetauscht werden. Für eine hohe Schnittqualität ist es erforderlich, beim Schneiden die Geometrie der Schneidkanten der Messer exakt einzustellen und einzuhalten.

Um die Standzeiten der Messer zu erhöhen, ist es aus der EP-0 297 399 B1 bekannt, die Schneidkanten aus einem Hartmetall zu fertigen. Das Aufbringen einer ein- oder mehrlagigen Hartstoffschicht bei einem bandförmigen Messer beschreibt die EP- 0 327 530 A2. Im Schneidkantenbereich eines aus niedrig legiertem, vorzugsweise nicht rostendem Stahl, insbesondere aus Kohlenstoffstahl, bestehenden Messers wird mittels eines gepulstem CPVD-Verfahrens eine Hartstoffschicht aus Nitrid, Karbid und/oder Oxid, Karbonnitrid und/oder Oxikarbonitrid der Elemente der Gruppen IV b, V b, VI b des periodischen Systems oder aus einem Nitrid der Elemente Bor, Aluminium, Silizium, Molybdän, Wolfram oder aus einem Titankarbonitrid und/oder Titannitrid aufgetragen.

Die Technik der lonenimplantation zur Verschleißminderung bei Stählen ist in der Broschüre "Plasmagestützte Verfahren der Oberflächentechnik" des Arbeitskreises Plasmaoberflächen-Technologie der Deutschen Gesellschaft für Galvano- und Oberflächentechnik e. V., Horionsplatz 6, D-40213 Düsseldorf, beschrieben. Bei der lonenimplantation werden durch Beschuß von Oberflächen mit energiereichen lonen chemischer Elemente diese in den Randbereich der Materialien eingelagert.

### Darstellung der Erfindung

Der Erfindung liegt die Aufgabe zugrunde, ein Messer zum Schneiden von laufenden Materialbahnen bereitzustellen, das bei kostengünstiger Fertigung hohe Standzeiten auch beim Schneiden. abrasiv wirkender Papier- oder Kartonbahnen aufweist.

Diese Aufgabe wird mit den Merkmalen des Patentanspruchs 1 gelöst.

Nach der Erfindung bestehen die Messer aus einem Messerkörper mit einer Schneidkante aus Stahl. Zumindest in die Oberfläche der Schneidkante werden mittels eines plasmagestützten CPVD-Verfahrens Fremdionen mit einer Eindringtiefe zwischen 50 µm und 500 µm, vorzugsweise 100 µm bis 200 µm, eingelagert. Diese Dotierung mit Fremdionen im Metallgitter bewirkt eine für das Schneiden optimale Verbesserung der Härte, ohne dass der Stahl zu spröde wird oder die Duktilität beeinflußt wird. Bevorzugt werden - wie im Patentansprucht 2 beansprucht - Fremdionen so eingelagert, daß zumindest die Schneidkante eine nach Vickers gemessene Härte von 800 HV bis 1300 HV, vorzugsweise 900 HV bis 1200 HV, insbesondere 950 HV bis 1050 HV, aufweist. Nach der Erfindung mit dieser Härte gefertigte Kreismesser haben in Längsschneidevorrichtungen eine mehrfach gesteigerte Standzeit, ohne dass die Schneidkanten unter Belastung ausbrechen. Mit diesen Messern lassen sich beim Längsschnitt hohe Schnittgenauigkeiten erzielen.

Als besonders geeignet hat sich die Einlagerung von Stickstoff-, Kohlenstoff-, Molybdän-, Wolfram- oder Titanionen in variablen Konzentrationen pro Mol Stahl gezeigt. Der Anteil von Molybdän- oder Wolframionen an der Gesamtmenge eingelagerter Fremdionen ist dabei vorteilhafterweise höher als der Anteil von Titanionen.

Als Stahl zumindest für die Schneidkante, bevorzugt für den gesamten Messerkörper, wird vorzugsweise ein Vergütungsstahl, beispielsweise ein Wälztagerstahl, ein Schnellarbeitsstahl oder ein Werkzeugstahl, insbesondere ein Kaltarbeitsstahl, beispielsweise ein hochlegierter Chrom-Vanadium-Stahl verwendet.

### Kurze Beschreibung der Zeichnung

Die Zeichnung dient zur Erläuterung der Erfindung anhand eines vereinfacht dargestellten Ausführungsbeispiels.

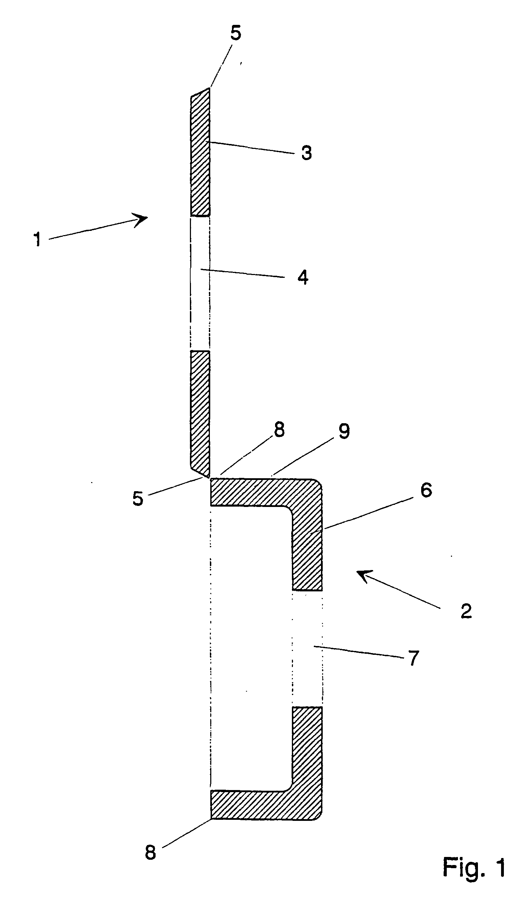

- Figur 1: zeigt einen Schnitt durch ein Kreismesserpaar einer Längsschneidevorrichtung zum Schneiden von Papier- oder Kartonbahnen.

### Wege zur Ausführung der Erfindung

Das Kreismesserpaar enthält als Obermesser 1 ein scheibenförmiges Kreismesser, als Untermesser 2 ein als Topfmesser gestaltetes Kreismesser. Derartige Messerformen sind beispielsweise in der DE 34 19 843-C2 oder der EP-0 297 399-B1 beschrieben.

Das Obermesser 1 weist einen scheibenförmigen Messerkörper 3 mit einer zentralen Bohrung 4 auf, mit der es über ein auf einer Messerwelle befestigtes Lager geschoben und an diesem befestigt wird. Radial außen ist der Messerkörper 3 kegelstumpfförmig abgeschrägt und läuft in einer scharfen Schneidkante 5 aus.

Das Untermesser 2 besteht aus einem topfförmigen Messerkörper 6, der ebenfalls eine zentrale Bohrung 7 aufweist, durch die beim Einbau in die Längsschneidevorrichtung auf eine Messerwelle geschoben wird. Die Schneidkante 8 des topfförmigen Untermessers 2 verläuft am radial äußeren Rand des zylinderförmigen Teils 9 des Messerkörpers 6, der in etwa rechtwinklig zur Bohrung 7 abgewinkelt und somit parallel zur Messerwelle verläuft.

Zumindest der Bereich der Schneidkanten 5, 8 der beiden Messer 1, 2, bevorzugt der gesamte Messerkörper 3, 6 einschließlich der Schneidkanten 5, 8, sind aus Stahl gefertigt. Bevorzugt wird ein Vergütungsstahl, ein Wälzlagerstahl, ein Schnellarbeitsstahl oder ein Werkzeugstahl verwendet, der anschließend auf die nachfolgend beschriebene Weise veredelt wird. Als besonders geeignet für Kreismesser zum Längsschneiden von Papier- oder Kartonbahnen hat sich ein Werkzeugstahl für Kaltarbeit, insbesondere ein hochlegierter Chrom-Vanadium-Stahl, als Grundmaterial erwiesen.

Nach Herstellung der Grundform des Messerkörpers 3, 6 wird zumindest die Schneidkante 5, 8, bevorzugt der gesamte Messerkörper 3, 6 mittels eines plasmagestützten Verfahrens durch lonenimplantation so behandelt, dass Fremdionen von außen in den äußeren Bereich des Metallgitters eingelagert werden. Die Dotierung mit Fremdionen wird so durchgeführt, dass Fremdionen bis zu einer Eindringtiefe von 50 lim bis 500 µm, vorzugsweise 100 µm bis 200 µm, eingelagert werden. Als Fremdionen werden Stickstoff-, Kohlenstoff-, Molybdän-, Wolfram und/oder Titanionen eingelagert. Bevorzugt ist der Anteil der Molybdän- oder Wolframionen an den Fremdionen größer als der Anteil von Titanionen.

Die Art der Fremdionen, die Verfahrenstemperatur und Einwirkdauer des gepulsten Plasmas wird dabei so eingestellt, dass zumindest die Schneidkante 5, 8, bevorzugt der gesamte Messerkörper 3, 6, eine nach Vickers gemessene Härte von 800 HV bis 1300 HV, vorzugsweise 900 HV bis 1200 HV, aufweist. Für Kreismesser zum Längsschneiden hat sich ein Härtebereich von 950 HV bis 1050 HV als besonders geeignet gezeigt. Die Behandlungstemperatur im Plasma bei der Behandlung beträgt 180° C bis 350° C, vorzugsweise 220° C bis 280° C.

## Patentansprüche

1. Messer, insbesondere zum Schneiden laufender Materialbahnen, mit einem Messerkörper (3, 6), der eine Schneidkante (5, 8) aus Stahl aufweist, **gekennzeichnet durch** eine Schneidkante (5,8), deren Oberfläche **durch** das plasmagestützte Verfahren der lonenimplantation behandelt ist, wobei standzeiterhöhende Fremdionen von außen bis zu einer Eindringtiefe von 50 µm bis 500 µm, vorzugsweise 100 µm bis 200 µm, im Metallgitter eingelagert sind.

2. Messer nach Anspruch 1, **dadurch gekennzeichnet, dass** zumindest die Schneidkante (5, 8) eine Härte von 800 HV bis 1300 HV, vorzugsweise 900 HV bis 1200 HV, insbesondere 950 HV bis 1050 HV, aufweist.

3. Messer nach Anspruch 1 oder 2, **dadurch gekennzeichnet, dass** zumindest für die Schneidkante (5, 8), bevorzugt für den gesamten Messerkörper (3, 6) ein Vergütungsstahl, ein Schnellarbeitsstahl oder ein Werkzeugstahl, insbesondere ein Kaltarbeitsstahl, verwendet wird.

4. Messer nach einem der Ansprüche 1 bis 3, **dadurch gekennzeichnet, dass** als Fremdionen Stickstoff-, Kohlenstoff-, Molybdän-, Wolfram und/oder Titanionen eingelagert sind.

5. Messer nach Anspruch 4, **dadurch gekennzeichnet, dass** der Anteil der Molybdänund Wolframionen an den Fremdionen höher ist als der Anteil von Titanionen.

6. Vorrichtung zum Längsschneiden einer laufenden Materialbahn, insbesondere einer Papier- oder Kartonbahn, Kunststoff- oder Metallfolie, mit einem oder mehreren Kreismesserpaar(en) jeweils bestehend aus einem Obermesser (1) und einem Untermesser (2), **dadurch gekennzeichnet, dass** das Obermesser (1) und/oder das Untermesser (2) ein Kreismesser mit den Merkmalen eines oder mehrerer der Patentansprüche 1 bis 5 ist.

7. Vorrichtung zum Querschneiden einer Materialbahn, insbesondere einer Papier- oder Kartonbahn, mit einer Messertrommel, die auf ihrer Mantelfläche mit einem oder mehreren sich über die Trommellänge erstreckenden Quermesser bestückt ist, **dadurch gekennzeichnet, dass** das Quermesser gemäß einem oder mehrerer der Patentansprüche 1 bis 5 gestaltet ist.

## Claims

1. Blade, in particular for cutting moving webs of material, having a blade body (3, 6) which has a cutting edge (5, 8) made from steel, **characterized by** a cutting edge (5, 8) the surface of which is treated by a plasma-assisted ion implantation process, in which foreign ions which increase the service life are incorporated from the outside down to a penetration depth of 50 µm to 500 µm, preferably 100 µm to 200 µm, in the metal lattice.

2. Blade according to Claim 1, **characterized in that** at least the cutting edge (5, 8) has a hardness of 800 HV to 1300 HV, preferably 900 HV to 1200 HV, in particular 950 HV to 1050 HV.

3. Blade according to Claim 1 or 2, **characterized in that** a heat-treated steel, a high-speed steel or a tool steel, in particular a cold-work steel, is used at least for the cutting edge (5, 8) preferably for the entire blade body (3, 6).

4. Blade according to one of Claims 1 to 3, **characterized in that** nitrogen, carbon, molybdenum, tungsten and/or titanium ions are incorporated as foreign ions.

5. Blade according to Claim 4, **characterized in that** the proportion of the foreign ions which is formed by molybdenum and tungsten ions is higher than the proportion formed by titanium ions.

6. Device for the longitudinal cutting of a moving web of material, in particular of a paper or board web, a plastic film or a metal foil, having one or more pair(s) of circular blades in each case comprising an upper blade (1) and a lower blade (2), **characterized in that** the upper blade (1) and/or the lower blade (2) is a circular blade having the features of one or more of Claims 1 to 5.

7. Device for the transverse cutting of a web of material, in particular of a paper or board web, having a blade drum which is provided on its lateral surface with one or more transverse blades extending over the length of the drum, **characterized in that** the transverse blade is designed as described in one or more of Claims 1 to 5.

## Revendications

1. Lame, en particulier pour couper des bandes de matériau en mouvement, comprenant un corps de lame (3, 6), qui présente une arête de coupe (5, 8) en acier, **caractérisée par** une arête de coupe (5, 8) dont la surface est traitée par le procédé d'implantation ionique en plasma, dans lequel des ions étrangers augmentant la durée de vie sont déposés dans le réseau métallique depuis l'extérieur jusqu'à une profondeur de pénétration de 50 µm à 500 µm, de préférence de 100 µm à 200 µm.

2. Lame selon la revendication 1, **caractérisée en ce qu'**au moins l'arête de coupe (5, 8) présente une dureté de 800 HV à 1300 HV, de préférence de 900 HV à 1200 HV, en particulier de 950 HV à 1050 HV.

3. Lame selon la revendication 1 ou 2, **caractérisée en ce qu'**on utilise, au moins pour l'arête de coupe (5, 8), de préférence pour tout le corps de lame (3, 6), un acier de traitement, un acier à coupe rapide ou un acier à outils, en particulier un acier pour travail à froid.

4. Lame selon l'une quelconque des revendications 1 à 3, **caractérisée en ce que** les ions étrangers déposés sont des ions azote, carbone, molybdène, tungstène et/ou titane.

5. Lame selon la revendication 4, **caractérisée en ce que** la proportion des ions molybdène et tungstène parmi les ions étrangers est plus élevée que la proportion des ions titane.

6. Dispositif de coupe longitudinale d'une bande de matériau en mouvement, en particulier d'une bande de papier ou de carton, d'une feuille de matière plastique ou de métal, comprenant une ou plusieurs paire(s) de lames circulaires se composant chacune d'une lame supérieure (1) et d'une lame inférieure (2), **caractérisé en ce que** la lame supérieure (1) et/ou la lame inférieure (2) est une lame circulaire ayant les caractéristiques d'une ou de plusieurs des revendications 1 à 5.

7. Dispositif de coupe transversale d'une bande de matériau, en particulier d'une bande de papier ou de carton, comprenant un tambour à lames qui est équipé sur sa surface périphérique d'une ou de plusieurs lame(s) transversale(s) s'étendant sur toute la longueur du tambour, **caractérisé en ce que** la lame transversale est configurée selon l'une ou plusieurs des revendications 1 à 5.
